(19) Europäisches Patentamt
European Patent Office
Office européen des brevets

(11) EP 3 075 799 A1

(12) **EUROPEAN PATENT APPLICATION**

(43) Date of publication:
**05.10.2016 Bulletin 2016/40**

(21) Application number: **15162472.3**

(22) Date of filing: **02.04.2015**

(51) Int Cl.:
***C09D 127/16*** *(2006.01)* ***C08L 27/16*** *(2006.01)*
***H01L 31/049*** *(2014.01)* *C08K 3/22* *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(71) Applicant: **Solvay Specialty Polymers Italy S.p.A.
20021 Bollate (MI) (IT)**

(72) Inventors:
- **Miozzo, Luciano
21100 Varese (VA) (IT)**
- **Bassi, Mattia
20144 MILANO (MI) (IT)**
- **Radice, Stefano Vincenzo
20821 MEDA (MB) (IT)**

(74) Representative: **Benvenuti, Federica et al
Solvay S.A.
Département de la Propriété Intellectuelle
Rue de Ransbeek, 310
1120 Bruxelles (BE)**

(54) **IR-REFLECTIVE MATERIAL**

(57) The present invention provides a composition comprising a combination of a fluorinated polymer, a non-fluorinated polymer and an inorganic filler comprising a Near IR-reflective metal oxide, an article comprising it and a method for producing the same article.

EP 3 075 799 A1

## Description

### Technical Field

The present invention provides a composition, suitable for use as a backsheet for a photovoltaic module, comprising a combination of a fluorinated polymer, a non-fluorinated polymer and an inorganic filler comprising a Near IR-reflective metal oxide, and a method for producing the same. In an embodiment, the present invention provides a photovoltaic cell comprising the backsheet.

### Background Art

Photovoltaic cells (PCs) have become of common use to generate power by conversion of light, especially sunlight, into electricity. Generally, a plurality of photovoltaic cells are interconnected to form a photovoltaic module. The active components of photovoltaic cells, that is the component capable of converting radiations into electricity, are perishable and sensitive to moisture. For this reason, photovoltaic cells need to be encapsulated in sheets of materials capable of providing protection from agents such as weather, dirt and pollution. In the most common design, the active component of the module, that is the component capable of converting radiations into electricity, is protected with a sheet of glass, or of transparent plastics, on the side to be exposed to radiations ("front sheet") and with a polymeric or composite layer on the opposite side ("backsheet").

In principle, photovoltaic cells produce electricity in amount that is directly proportionally to their exposure to radiations, i.e. the electrical output rises as the intensity of the incident radiation increases. In reality, however, in photovoltaic cells the efficiency of conversion of light into energy is low (between 20% and 25% for silicon-based technologies), and most of the sunlight is absorbed without being transformed into net flow current. The sunlight absorption causes an increase of the module temperature, which, in turn, lowers the efficiency of the cell. In fact, photovoltaic cells are sensitive to heating, as increases in temperature reduce the open circuit voltage and, therefore, the photoconversion efficiency.

The temperature sensitivity of a solar cell depends on the open circuit voltage of the solar cell, with higher voltage solar cells being less affected by temperature. For silicon, the temperature dependency of Voc is of about -2.3 mV/°C. Backsheets are generally white, but can also be black, or dark-coloured, for aesthetical reasons. Absorption of the incident radiation by the dark materials contributes to increasing the temperature of the photovoltaic modules.

One approach to limit this drawback is active heat dispersion by means of cooling or heat-removing systems such as refrigerating circuit and heat sinks. This approach requires additional elements and extra energy consumption, which ultimately limit the overall efficiency of the system. US 7985919 B (NANOSOLAR INC) 26/07/2011 discloses a photovoltaic device comprising a thin-film active stack deposited directly onto a thermally conductive substrate that is connected to a heat sink, in a configuration to allow sufficient heat transfer to lower the operating cells of the cell.

Alternatively, substances that enhance reflection of the incident radiation can be included in the backsheet, so that heating due to absorption is at least partially reduced (passive heat dispersion). US 2013/0276876 A (HONEYWELL INTERNATIONAL) 24/10/2013 discloses backsheets for photovoltaic modules having at least two adjacent polymeric layers, wherein each layer includes infrared reflective pigments with a wavelength-specific reflectance that is different from that of the other layer. This type of multilayer material is rather laborious to produce and results in thicker panels, as its production requires manufacturing at least two different types layers and laminating them, optionally interposing an additional adhesive layer. Thick modules can be unsuitable for certain applications, such as power sources for portable or miniaturised devices.

The demand for a photovoltaic cell keeping high efficiency of conversion of light into energy in very hot environments is presently unmet.

One aim of the present invention is to provide a photovoltaic cell with improved efficiency and that can be easily and cost-efficiently manufactured via standard techniques known to the person skilled in the art.

Another object of the present invention is to provide a material having high radiation reflectivity, particularly in the IR spectrum, which can be easily employed in a wide number of applications where heat management is required.

### Summary of invention

The present invention achieves these aims by providing a composition that includes:

a) a fluoropolymer;
b) an acrylate- or methacrylate-based co-polymer comprising 20-80% wt of recurring units derived from methyl methacrylate or methyl acrylate monomer and 20-80% wt of recurring units derived from a $C_2$-$C_8$ alkyl methacrylate or acrylate monomer, optionally with additional co-monomers; c) an inorganic filler, comprising a metal oxide, that

reflects not less than 70% of at least an incident radiation having a wavelength comprised in the range from 0.78 micrometer to about 3 micrometers, wherein the filler c) is in the form of particles having an average size from 2 to 10 micrometers, preferably 3.5 to 8 micrometers, the weight ratio of fluoropolymer a) to acrylate-based polymer b) is from 90:10 to 30:70 and the refractive index ($n_1$) of the mixture of a) and b) and the refractive index ($n_2$) of the filler c) are such that the ratio $n_1/n_2$ is not higher than 0.8.

The inventors found that using a composition comprising a mixture of a fluoropolymer and an acrylate-based polymer in a specific ratio unexpectedly enhances the IR-reflecting properties of metal oxide-based fillers. This is particularly advantageous in applications, such as forming backsheets for photovoltaic modules, where passive heat dispersion is sought. The composition of the invention displays excellent IR reflectivity also when applied to a surface as a monolayer. This feature is particularly advantageous for applications where reducing the thickness and weight of the heat-dispersing layers is a requisite, such as in the field of portable and high-tech devices. The reflectivity of the compositions according to the invention remains substantially stable and, in some case, actually improves over time in ageing experiments, which is advantageous for applications, such as outdoor solar panels, where weatherability is an important feature.

The inventors found that a composition in form of a sheet with these advantageous properties can be conveniently manufactured via a method comprising:

i. preparing a solution or a suspension of fluoropolymer a) in a first liquid medium;
ii. adding co-polymer b) to the solution or suspension of step i.;
iii. adding to the mixture obtained in step iii. the inorganic filler c) under stirring to obtain a homogeneous suspension;
iv. processing the suspension of step iii. under the form of a sheet.

**Brief description of drawings**

Figure 1: reflectivity spectrum of a composition comprising PVDF polymer and $TiO_2$ powder having average particle size = 0.5 micrometers.

Figure 2: reflectivity spectrum of a composition comprising PVDF polymer and Cr-Sb-$TiO_2$ rutile

Figure 3: reflectivity at wavelength = 1200 nm of compositions comprising a Cr-Sb-$TiO_2$ rutile pigment c) (Sicotan Yellow®) having average particle size (D50)= 3.5 micrometers and PVDF/acrylate copolymer mixtures varying the content of PVDF polymer (the remaining portion to 100% being acrylate copolymer).

Figure 4: reflectivity of compositions comprising a Cr-Sb-$TiO_2$ rutile pigment c) (Sicotan Yellow®) having average particle size (D50)= 3.5 micrometers and PVDF/acrylate copolymer mixtures varying the content of PVDF polymer (the remaining portion to 100% being acrylate copolymer) at wavelength range = 200 to 2400 nm.

Figure 5: reflectivity at wavelength = 1400 nm of comparative compositions (prepared according to Comparative Example 2) comprising a pigment having average particle size (D50)= 1 micrometer and PVDF/acrylate copolymer mixtures varying the content of PVDF polymer (the remaining portion to 100% being acrylate copolymer).

Figure 6: reflectivity of comparative compositions comprising a pigment having average particle size (D50)= 1 micrometer and PVDF/acrylate copolymer mixtures varying the content of PVDF polymer (the remaining portion to 100% being acrylate copolymer) at wavelength range = 990 to 2010 nm.

Figure 7: result of ageing experiments showing the normalized reflectivity (i.e. ratio between initial reflectivity and reflectivity after a given time) at 1400nm for different compositions comprising a pigment c) (according to the invention) and 100% PVDF or the same pigment and mixtures of a PVDF polymer and an acrylate polymer in the ratios 70:30, 50:50, 30:70.

**Description of embodiments**

Unless otherwise specified, in the context of the present invention all percentages relative to a component in a mixture are calculated as the ratio of the weight of a specific component of a mixture divided by the total weight of the mixture (indicated as wt/wt).

In the context of the present invention, the term "encapsulant" indicates, broadly and without limitation, compounds or materials useful for laminating, adhering, adjoining, gluing, sealing, caulking and/or joining at least a portion of components, in particular of the active component, of a semiconductor, a photovoltaic panel, a photovoltaic (solar) module, a solar array and/or any other suitable assembly.

As used herein, the term "backsheet" indicates, broadly and without limitation, at least a portion of a layer or a cover on a side opposite the light-facing side of a semiconductor, a solar panel, a solar module, a solar array and/or any

other suitable assembly. The backsheet may preferably exhibit at least good weatherability and performance stability when exposed for prolonged periods to the normal use conditions of the assembly it is part of. Optionally, the backsheet may be in the form of a multilayer material formed by laminating, gluing or stacking at least two layers of materials that can be equal or different. The backsheet may optionally exhibit dielectric properties, that are advantageous, for example, for preventing short circuiting and/or for allowing reliable operation of a device. The backsheet may consist of a single sheet, e.g. of compounded polymer, or, alternatively, it may be a multiple-layer structure (laminate) where each layer may have different properties depending upon the price and performance requirements of the backsheet. For example, in one embodiment, the backsheet is a laminate with an inner layer of an adhesive polymeric layer adhered to an outer weatherable layer. For another example, the layer comprising the composition according to the invention may be the middle layer of a three-layer laminate that includes an outer weatherable layer and an inner layer that provides adhesion to the cell or encapsulant and/ reflectance enhancement of the backsheet. These additional layers may be polyolefin-based adhesives or EVA or another material typically used in backsheet construction.

The backsheet of a photovoltaic module typically has a thickness of 200 to 500 micrometers, wherein the layer of the composition according to the invention is generally 10-100 micrometers, preferably 20-50 micrometers, more preferably 20-30 micrometers. As a non-limiting example, in the case of a backsheet formed by casting the composition of invention on a biaxially-oriented polyethylene terephthalate (BOPET), the backsheet has an overall thickness around 280 micrometers, wherein the coating comprising the composition of the invention has thickness around 20-30 micrometers. In a case of a backsheet comprising a sheet formed from melt techniques, the overall thickness of the backsheet is 300 micrometers and the coating comprising the composition of the invention has thickness around 20-30 micrometers.

Regarding the active component and the configuration of the cell, the person skilled in the art will recognize that any of the embodiments of the present invention can be applied to almost any type of solar cell material and/or architecture. For example, the active material can be any of silicon, amorphous silicon, organic oligomers or polymers (for organic solar cells), bi-layers or interpenetrating layers or inorganic and organic materials (for hybrid organic/inorganic solar cells), dye-sensitized titanium oxide nanoparticles in a liquid or gel-based electrolyte (for Graetzel cells in which an optically transparent film comprised of titanium dioxide particles a few nanometers in size is coated with a monolayer of charge transfer dye to sensitize the film for light harvesting), copper-indium-gallium-selenium (for "CIGS" solar cells), CdSe, CdTe, $Cu(In,Ga)(S,Se)_2$, $Cu(In,Ga,Al)(S,Se,Te)_2$, and/or combinations of the above, where the active materials are present in any of several forms including, but not limited to, bulk materials, micro-particles, nano-particles, or quantum dots. The CIGS, amorphous silicon, organic oligomers, dye-sensitized, CdSe, CdTe cells may be formed by vacuum or non-vacuum processes. The processes may be one stage, two stage, or multi-stage processing techniques. Additionally, other possible active components may be based on amorphous silicon (doped or undoped), a nanostructured layer having an inorganic porous semiconductor template with pores filled by an organic semiconductor material, a polymer/blend cell architecture, organic dyes, and/or $C_{60}$ molecules, and/or other small molecules, micro-crystalline silicon cell architecture, randomly placed nanorods and/or tetrapods of inorganic materials dispersed in an organic matrix, quantum dot-based cells, or combinations of the above. Some of these types of cells can be fabricated on flexible substrates.

In the context of the present invention, the term "fluoropolymer" indicates a polymer or co-polymer comprising at least 50% of all recurring units that derive from a partially fluorinated or completely fluorinated (perfluorinated) monomer. In a preferred embodiment, the composition of the invention comprises a fluoropolymer selected from a vinylidene fluoride-based polymer (PVDF), a polyvinyl fluoride (PVF), an ECTFE-based polymer and a ETFE-based polymer.

As used herewith, the term "vinylidene fluoride-based polymer" (PVDF) indicates a polymer or co-polymer comprising more than 50 % in weight (wt/wt) of recurring units derived from the polymerization of vinylidene fluoride monomer (difluoro 1,1-ethylene, VF2 or VDF). For the purpose of the present invention, the vinylidene fluoride polymer may optionally comprise, in addition to the VDF monomer, recurring units deriving from the polymerization of ethylenically unsaturated monomers different from VDF (for example 10-20 % in weight with respect to the total weight of the composition). Said ethylenically unsaturated monomers may comprise at least one fluorine atom and can be hence designated as fluorinated comonomers. Still, the ethylenically unsaturated monomers can be free from fluorine atoms; examples of these non-fluorinated comonomers are notably acrylic monomers, including (meth)acrylic acid, hydroxyalkyl(meth)acrylates, and the like). The hydrophilic (meth)acrylic monomer (MA) preferably complies to formula:

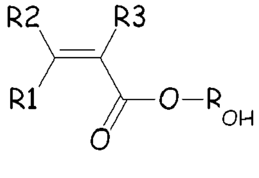

wherein each of R1, R2, R3, equal or different from each other, is independently a hydrogen atom or a $C_1$-$C_3$ hydrocarbon group, and $R_{OH}$ is a hydrogen or a $C_1$-$C_5$ hydrocarbon moiety comprising at least one hydroxyl group. Non limitative

examples of hydrophilic (meth)acrylic monomers (MA) are notably acrylic acid, methacrylic acid, hydroxyethyl (meth)acrylate, hydroxypropyl(meth)acrylate; hydroxyethylhexyl (meth)acrylates.The monomer (MA) is more preferably selected from:

- hydroxyethylacrylate (HEA) of formula:

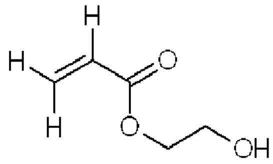

- 2-hydroxypropyl acrylate (HPA) of either of formulae:

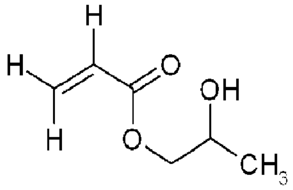

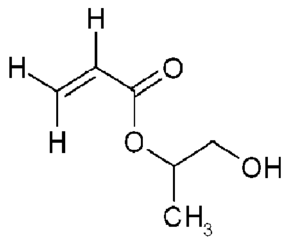

- acrylic acid (AA) of formula:

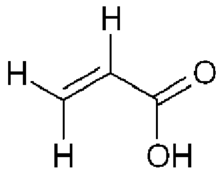

- and mixtures thereof.

Most preferably, the monomer (MA) is AA and/or HEA. Non-limiting examples of fluorinated comonomers different from VDF, as above detailed, comprise, notably, the following:

(i) $C_2$-$C_8$ fluoroolefins such as trifluoroethylene (TrFE), tetrafluoroethylene (TFE) and hexafluoropropylene (HFP);
(ii) perfluoroalkylethylenes of formula $CH_2$=CH-$R_{f0}$, wherein $R_{f0}$ is a $C_2$-$C_6$ perfluoroalkyl group;
(iii) chloro- and/or bromo- and/or iodo-$C_2$-$C_6$ fluoroolefins such as chlorotrifluoroethylene (CTFE);
(iv) perfluoroalkylvinylethers of formula $CF_2$=CFO$R_{f1}$, wherein $R_{f1}$ is a $C_1$ -$C_6$ perfluoroalkyl group, such as perfluoromethylvinylether (PMVE) and perfluoropropylvinylether (PPVE);
(v) (per)fluorooxyalkylvinylethers of formula $CF_2$=CFO$X_0$, wherein $X_0$ is a $C_1$-$C_{12}$ oxyalkyl group or a $C_1$-$C_{12}$ (per)fluorooxyalkyl group having one or more ether groups, e.g. perfluoro-2-propoxy-propyl group;
(vi) (per)fluoroalkylvinylethers of formula $CF_2$=CFO$CF_2$O$R_{f2}$, wherein $R_{f2}$ is a $C_1$-$C_6$ (per)fluoroalkyl group, e.g. -$CF_3$, -$C_2F_5$, -$C_3F_7$, or a $C_1$-$C_6$ (per)fluorooxyalkyl group having one or more ether groups, e.g. -$C_2F_5$ -O-$CF_3$;
(vii) functional (per)fluorooxyalkylvinylethers of formula $CF_2$=CFO$Y_0$, wherein $Y_0$ is selected from a $C_1$-$C_{12}$ alkyl group or (per)fluoroalkyl group, a $C_1$-$C_{12}$ oxyalkyl group and a $C_1$-$C_{12}$ (per)fluorooxyalkyl group having one or more ether groups, $Y_0$ comprising a carboxylic or sulfonic acid group, in its acid, acid halide or salt form;
(viii) fluorodioxoles, especially perfluorodioxoles;
(ix) vinyl fluoride,

and their mixtures.

Most preferred fluorinated comonomers are chlorotrifluoroethylene (CTFE), trifluoroethylene (TrFE), tetrafluoroethylene (TFE), hexafluoropropylene (HFP), perfluoromethylvinylether (PMVE).

Preferably, the fluoropolymer in the composition of the invention is a VDF polymer comprising :

(a') at least 60 % by weight preferably at least 75 % by weight, more preferably at least 85 % by weight of vinylidene fluoride (VDF);

(b') optionally from 0.1 to 15 %, preferably from 0.1 to 12 %, more preferably from 0.1 to 10 % by weight of a fluorinated comonomer chosen among vinylfluoride (VF 1), chlorotrifluoroethylene (CTFE), hexafluoropropene (HFP), tetrafluoroethylene (TFE), trifluoroethylene (TrFE), perfluoromethylvinylether (PMVE) and mixtures therefrom; and (c) from 0.05 to 10 %, preferably from 0.1 to 7.5 %, more preferably from 0.2 to 3.0 % by weight of a monomer selected from the group consisting of: hydroxyethylacrylate (HEA), 2-hydroxypropyl acrylate (HPA), acrylic acid and mixtures thereof. In a most preferred embodiment, the fluoropolymer comprises about 85 weight% of units derived from VDF and about 15 weight% of units derived from HFP, wherein all the percentages are calculated as the ratio of the weight of a specific component of the copolymer divided by the total weight of the copolymer.

As used herein, the terms "ECTFE-based" and "ETFE-based polymer" indicate a co-polymer comprising :

(a) recurring units derived from ethylene (E);

(b) recurring units derived from chlorotrifluoroethylene (CTFE), tetrafluoroethylene (TFE) or mixture thereof; and

(c) from 0 to 5%, preferably from 0 to 2.5 % by moles, based on the total amount of monomers (a) and (b), of recurring units derived from one or more fluorinated and/or hydrogenated comonomer(s),

with respect to the total number of moles of recurring units.

Preferably the comonomer is a hydrogenated comonomer selected from the group of the (meth)acrylic monomers. More preferably the hydrogenated comonomer is selected from the group of the hydroxyalkylacrylate comonomers, such as hydroxyethylacrylate, hydroxypropylacrylate and (hydroxy)ethylhexylacrylate, and alkyl acrylate comonomers, such as n-butyl acrylate.

As used herein, the expression "acrylate- or methacrylate-based co-polymer" indicates a polymer (b) consisting essentially of recurring units having a structure deriving from acrylic acid ($CH_2=CHCO_2H$) and/or from methacrylic acid (methylpropenoic acid, $CH_2=C(CH_3)CO_2H$). In the acrylate- or methacrylate-based co-polymer comprised in the composition of the invention, 0-80% wt of recurring units derive from methyl methacrylate or methyl acrylate monomer and 20-80% wt of recurring units derived from $C_2$-$C_8$ alkyl methacrylate or acrylate monomer, optionally with additional co-monomers, provided that the additional co-monomers of polymer (b) in a composition are different from the fluorinated monomer of polymer (a) in the same composition. Preferably, said $C_2$-$C_8$ alkyl methacrylate or alkyl acrylate monomers are ethyl, propyl, isopropyl, butyl, isobutyl, 2-ethylhexyl methacrylate or acrylates, or mixtures thereof. More preferably, the $C_2$-$C_8$ alkyl methacrylate or alkyl acrylate monomer is ethyl acrylate or methacrylate.

In a preferred embodiment of the composition comprised in the backsheet according to the invention, the acrylate-based co-polymer b) is a co-polymer comprising 20-80% wt of recurring units derived from methyl methacrylate monomer and 20-80% wt of recurring units derived from a $C_2$ -$C_8$ alkyl methacrylate or acrylate monomer.

Preferably, the acrylate-based polymer b) is a co-polymer comprising 40-80% wt, preferably 50-80% wt, more preferably 60-70% wt, of recurring units derived from methyl methacrylate monomer and 20-60% wt, preferably 20-50% wt, more preferably 30-40% wt, of recurring units derived from $C_2$-$C_4$ alkyl acrylate, more preferably from ethyl acrylate.

In the context of the present invention, infrared-reflective substances are inorganic pigments that reflect at least 70% of an incident infrared (IR) light having wavelength in the range from about 0.78 micrometers to about 3 micrometers, i.e. in the NIR range according to the ISO 20473:2007 definition, as measured on the substance as is, i.e. not encapsulated.

Reflection is the process where a fraction of the radiant flux incident on a surface is returned into the same hemisphere whose base is the surface and which contains the incident radiation. The reflection can be specular (in the mirror direction), diffused (scattered into the entire hemisphere), or a combination of both (Ref. Bass, M. et al. "Handbook of Optics", Third Edition Volume II: Design, Fabrication and Testing, Sources and Detectors, Radiometry and Photometry, 13 Oct. 2009 chapters 25.5 "Reflectance", 25.11 "Measurement of Reflectance" and references cited therein).

Reflectivity (or reflectance) is measured as the ratio between the intensity of reflected light and the intensity of incident light multiplied by 100, wherein the intensity is measurable by standard method and equipment, such as an IR spectrophotometer. Infrared-reflecting substances suitable for the composition of the invention do not necessarily reflect the totality of infrared radiation of a wavelength in said range and do not necessarily reflect all the wavelength in the range at an equal level. For example, a substance in the filler c) according to the invention can reflect 70-80% of incident radiation of a given wavelength in the NIR range and reflect less than 20% of an incident radiation of another wavelength in the NIR range. Preferably, the inorganic substances comprised in the backsheet of the present invention as component c) reflect at least 80%, more preferably at least 90%, of the incident radiation in the Near IR range (NIR), namely having wavelength from about 0.78 micrometers to about 3 micrometers.

Infrared-reflective substances are comprised in the composition of the present invention in the form of filler, i.e. they are inorganic substances homogenously dispersed in a polymeric matrix (binder) that, in the case of the instant invention, enhance the IR-reflectivity and, ultimately, improve the thermal properties of the composition, i.e. the dissipation

of heat. Near IR-reflective inorganic substances in the composition of the present invention can be superficially treated, i.e. their surface has been contacted or impregnated with substances, such as organic silanes or long-chain (organic) fatty acids, which affect the properties and reactivity of the inorganic substance. However, preferably, the filler c) in the composition according to the invention does not comprise superficially treated particles.

Non-limiting examples of the Near IR-reflective substances are inorganic metal oxides comprising titanium black ($Ti_2O_3$) or titanium dioxide where selected atoms, such as nickel, chromium, antimony and manganese, are incorporated in the crystal lattice of $TiO_2$, and hematite-structured metal oxides such as chrome-iron oxides and spinel-structured metal oxides such as zinc oxide, cobalt oxide and bismuth vanadate. NIR scatterers/reflectors suitable for use as filler c) in the composition of the invention comprise substances based on $TiO_2$, nickel titanate, chrome titanate yellows, mixed-metal oxide blacks, iron and chromium oxides, $Co_2$ $TiO_4$, titanium oxide on mica flakes, aluminium oxide, AlN, barium sulphate, lithopone (ZnS white), zinc sulphide zinc oxide, calcium carbonate.

In a preferred embodiment, the inorganic filler (c.) in the composition of the invention comprise a near IR-reflective metal oxide consisting of titanium dioxide incorporating in the $TiO_2$ crystal lattice metal atoms, more preferably atoms of metals of the IB-VIIB groups of the periodic table, most preferably atoms of nickel, chromium, antimony, manganese and mixtures thereof. In a preferred embodiment, the inorganic filler (c.) comprises at least a rutile pigment based on chromium(III)/antimony(V)/titanium dioxide.

Pure titanium dioxide can be used as an IR-reflective filler in backsheets for photovoltaic modules, however it was found that its IR reflectivity in the NIR range is poor, resulting in heating of the backsheet upon exposure to solar radiation. In addition, it was observed that fluoropolymers can react with $TiO_2$ at high temperature, releasing hydrofluoric acid, which is harmful and corrosive. CN 103832038 A (JIANGSU HOWEL PV TECHNOLOGY CO LTD) 04/06/2014 discloses a process for the production of a backsheet comprising inorganic fillers, wherein titanium dioxide is superficially treated with an organic silane to reduce its cracking catalytic activity on PVDF at high temperature. To avoid decomposition of PVDF, it is advantageous to reduce the amount of titanium dioxide filler in the compositions that comprise fluoropolymers.

Notably, the composition according to the invention exhibits high reflectivity for a wide range of IR radiations in the presence of a small amount of $TiO_2$ (or its analogues/derivatives). Without wishing to be bound by theory, this advantage is likely due to the specific ratio of fluoropolymer and acrylate- or methacrylate-based polymer used in the composition of the invention, which unexpectedly enhances the IR reflectivity of the filler above the level of fluoropolymer alone and of mixture of fluoropolymers and acrylate/methacrylate polymers in other ratios. Notably, it is not necessary that the surface of the inorganic oxides in the composition of the invention be treated with organosilicon compounds or any other chemical agent. The fillers in the composition of the invention are standard and commercially available and no pre-treatment steps is needed, hence the method of preparation is simple and cost-effective. Advantageously, the high reflectivity of the backsheet according to the present invention contributes to passive heat management, as it reduces the amount of IR radiation that is absorbed and contributes to increasing the temperature of the module.

Within the context of the present invention, the term "particle" is intended to denote a small mass of material that, from a geometrical point of view, has a definite three-dimensional volume and shape, characterized by three dimensions, wherein none of said dimensions exceed the remaining two other dimensions of more than 200%. Particles are generally not equidimensional, i.e. that are longer in one direction than in others.

The shape of a particle can be notably expressed in terms of the sphericity Φs, which is independent of particle size. The sphericity of a particle is the ratio of the surface-volume ratio of a sphere with equal volume as the particle and the surface-volume ratio of the particle. For a spherical particle of diameter Dp, Φs=1; for a non-spherical particle, the sphericity is defined as

$$\Phi s = (6.vp)/(Dp.Sp)$$

wherein:

Dp is the equivalent diameter of particle;
Sp is the surface area of one particle;
vp is the volume of one particle.

The equivalent diameter is defined as the diameter of a sphere of equal volume. Dp is usually taken to be the nominal size based on screen analysis or microscopic analysis. The surface area is found from adsorption measurements or from the pressure drop in a bed of particles.

The particles of filler (c) have a sphericity Φs of preferably at least 0.6, more preferably at least 0.65, even more preferably at least 0.7. Good results have been obtained with particles having a Φs from 0.7 to 0.95.

As used herein, the term "average" or "D50" particle size indicates the median diameter, i.e. the particle size such that 50 percent of the material is composed of particles larger than the stated D50 value, and 50 percent of the material is composed of particles smaller than the stated D50 value. The particles size of filler (c) according to the present invention can be determined according to a method known to the person skilled in the art, for example via laser diffraction methods (such as ISO 13320:2009) or by sieving methods.

The particles of filler (c) in the composition according to the present invention have average particle size from 1 to 10 micrometers, preferably from 2 to 9 micrometers or from 3.5 to 8 micrometers, more preferably from 4 to 6 micrometers.

The composition in the backsheet of the invention can comprise additives known to the person skilled in the art. The specific additive used will depend on the desired property of either the end product or a property helpful to the manufacture. Examples of additive that may be used include but not limited to UV absorbers (UVAs), hindered amine light stabilizers (HALs), light stabilizers, anti-oxidants (AOs), thermally conductive/ electrically resistive pigments, optical brighteners/photo-luminescent agents, visible light pigments, IR reflecting pigments, and their combinations.

In preferred embodiments, in the composition of the invention the ratio of fluoropolymer a) to acrylate polymer b) (calculated in weight of a) to weight of b)) is from 85:15 to 40:60, preferably from 80:20 to 50:50, more preferably from 72:28 to 60:40, even more preferably from 70:30 to 65:35 .

In preferred embodiments, in the composition of the invention the sum of fluoropolymer a) and of acrylate polymer b) is from 50 to 95%wt, preferably 66 to 75%wt and the amount of inorganic filler c) is from 5 to 50, preferably 25 to 33 %wt, all amounts referred to the total weight of the composition.

In preferred embodiments, the ratio ($n_1/n_2$) between the refractive index ($n_1$) of the mixture of a) and b) and the refractive index ($n_2$) of the filler c) is from 0.8 to 0.3, preferably from 0.7 to 0.3. In the context of the present invention, the refractive indexes are referred to the radiation in the Near IR range (NIR), namely from about 0.78 micrometers to about 3 micrometers, and are determined according to the methods known to the person skilled in the art, for example by ASTM D542-14.

As non-limitative examples, $n_1$ is typically from 1.3 to 1.5, e.g. 1.41 to 1.49 or 1.43 to 1.47, and $n_2$ is 2.1 to 2.7.

The composition according to the invention can be processed via any method known to the person skilled in the art, such as extrusion, casting and injection moulding, although methods that avoid heating the components to high temperatures are particularly advantageous.

In an embodiment, the present invention provides a sheet comprising the composition as defined above.

The present invention also provides a method for producing a sheet comprising the composition as described above, comprising the steps of:

i. preparing a solution or a suspension of fluoropolymer a) in a first liquid medium;
ii. mixing co-polymer b) with the solution or suspension of step i.;
iii. mixing to the composition obtained in step iii. the inorganic filler c) under stirring to obtain a homogeneous suspension;
iv. processing the suspension of step iii. under the form of a sheet.

Copolymer b) and filler c) can be mixed, respectively in step ii. and step iii., as dry solids or in a solution or suspension in a suitable liquid medium, optionally in the presence of additives.

The addition of the components a), b) and/or c) can be carried out in the form of a masterbatch, i.e. in a solid or semi-solid composition wherein each of the components is dispersed in high concentration in a carrier material that is compatible with the main polymeric material in which it will be blended, whereby the final product will obtain at least part of its properties from the masterbatch.

Advantageously, the method for producing the composition according to the present invention in the form of a sheet does not require extrusion or any other treatment at high temperature.

As used herewith, the term "liquid medium" indicates a liquid substance, or combination of substances, that are suitable to dissolve or suspend the polymers in the composition according to the invention.

In the context of the present invention, the "suspension" indicates heterogeneous liquid/solid systems including emulsions, microemulsions, latexes and stable or unstable dispersions of at least one polymeric material in a liquid medium. Suitable liquid media for step i. and ii. comprise in general ketones, amides and sulfoxides such as acetone, methyl ethyl ketone (MEK), DMF, DMA, NMP, NEP, DMSO, water and their mixtures.

In step iv. of the method according to the present invention the composition may be formed in a sheet by casting on any suitable substrate for solution film casting, such as a glass or metal surface, or a polymeric material such as biaxially-oriented PET. Preferably, in the method of the invention the substrate for film casting is a biaxially-oriented PET sheet, so as to obtain a multilayer material that is suitable for use as a backsheet in a photovoltaic cell.

Solution casting can be carried out by means of a doctor blade or by any suitable method known to the person skilled in the art.

Optionally, in the case of forming a sheet by casting a suspension that comprises the composition including a), b) and c) according to the invention, the process comprises the additional steps of:

v. drying the suspension cast on the substrate to remove the liquid medium;
vi. thermally annealing the system obtained in step v. to improve film formation.

Depending on the nature of the liquid medium, the drying step v. can be carried out at room temperature or in a dedicated environment, such as an oven, optionally pre-heated, at a temperature suitable to obtain complete evaporation of the liquid medium, e.g. within 2-12 hours, optionally under reduced pressure.

Alternatively, in step iv. of the method according to the present invention the composition may be formed into a sheet via the techniques known to the person skilled in the art for film formation that avoid the use of a solution or suspension, such as melt formation, extrusion, moulding, and the like.

The composition of the invention can be processed under the form of a film by cast extrusion or hot blown extrusion techniques, optionally with mono- or bi-axial orientation.

A technique particularly adapted to the manufacture of films of the composition of the invention involve extruding the composition, as above detailed, in the molten state through a die having elongated shape so as to obtain an extruded tape and casting/calendering said extruded tape so as to obtain a film.

In an embodiment, the present invention pertains to an article comprising the composition as described above.

Preferably, the article according to the invention is in the form of a multi-layer object, wherein at last one of the layers comprises the composition as above described. More preferably, said article is in the form of a photovoltaic panel, a photovoltaic cell, a panel for use in architecture, for building greenhouses, for applications in the automotive and aeronautical fields and in general for applications wherein resistance to weather exposure and temperature control is required.

In an embodiment, the present invention provides a photovoltaic module comprising the backsheet as described above.

In an embodiment, the present invention provides a method of producing a multi-layer article, said method comprising coating a layer of non-plastic material or non-fluoropolymeric plastic material with a solution or suspension comprising the composition comprising polymers a) and b) and inorganic filler c) as described above.

In another embodiment, the present invention provides a method of producing a multi-layer article, said method comprising laminating a layer of non-plastic material or non-fluoropolymeric plastic material with a layer comprising the composition comprising polymers a) and b) and inorganic filler c) as described above.

As used herein, "non-plastic material" indicates any material that consists of non-polymeric substances. Non-limiting examples of non-plastic materials are metal, metal alloys, wood, paper, fabric, non-woven fabric, glass, glass fibre, carbon, graphite etc.

As used herein, "non-fluoropolymeric plastic material" indicates a polymeric material that is formed out of a polymeric substance that does not comprise fluorinated recurring units. Non-limiting examples of such materials are polypropylene, polyamides, polyethylene terephtalates (PET), polyethylene and the like. A preferred non-fluoropolymeric plastic material in the method of the invention is PET, more preferably biaxally-oriented PET (BO-PET).

The following examples are provided to illustrate specific embodiments of the present invention, without limiting its scope.

Starting materials:

Polymers:

a) PVDF polymer comprising 15% in weight/total weight of the polymer of HFP (hexafluoropropene);
b) Polyacrylate: Paraloid® B-44, PMMA granules supplied by DOW (the mixtures of polymers a) and b) in the examples have refractive index $n_1$ comprised between 1.41 and 1.49)
c) Inorganic filler: Sicotan® Yellow K 2001 (D50 = 3.5 micrometers, $n_2$= 2.6), supplied by BASF.

The composition of comparative example 1 was prepared using 100% a) and filler c) according to the invention in the form of particles having an average size from 2 to 10 micrometers.

The composition of comparative Example 2 was prepared using a filler (Sicopal Black ® supplied by BASF) having average particle size (D50) = 1 micrometer and $n_2$= 2.08 (Figures 5 and 6).

The relative amounts of a) and b) for the preparation of the test samples in Figures 3-7 are varied as specified in the figures.

The amount of filler in the test samples is 30% in weight with respect to the total weight of the composition.

Dispersion preparation: A solution of polymer is prepared by adding the desired amount of fluoropolymer a) to a weighted amount Methyl Ethyl Ketone (MEK) in a glass container, at room temperature under stirring; the polyacrylate b) is added to the solution after the complete solubilization of the fluoropolymer in MEK (generally achieved after 2 hours at room temperature under stirring). After complete solubilization of the polyacrylate, a weighted amount of the inorganic filler (c) is added at to the solution under stirring.

The dispersion is then kept under stirring for 30 min before proceeding with film preparation.

Device fabrication:

Coating preparation: an A4-sized Bioriented PET sheet is used as substrate for the preparation of the fluoropolymer/polyacrylate/filler film. Coating is obtained using a doctor blade; the thickness of the coating spans from 10 to 100 microns. The coating is made usually at room temperature. After coating deposition, the coated film is dried under vacuum (p= 25 mmHg at 70°C) for 10 minutes. Optionally, the film can be annealed to improve homogeneity.

Minimodule preparation: optionally, a photovoltaic module can be prepared by lamination of a polycrystalline silicon solar cell; the film according to the invention is used as backsheet, a sheet of Halar® ECTFE or a high-transparency glass plate as frontsheet and EVA as encapsulant. The lamination process can be made with a vacuum Laminator, with a multistep program at high temperature

Measurement protocol: the film coated with the composition according to the invention is illuminated with a Xenon lamp with a power density of 100 $mW/Cm^2$, as described in IEC 61215. Temperature drift is measured with a multichannel datalogger Daq PRO 5300 equipped with thermocouples Model 88309K-IEC , with a scan rate of 1 Hz.

Reflectance spectra have been collected with a Shimdazu 3600 spectrophotometer, equipped with a LISR-3100 Integrating Sphere attachment, whose diameter is 150 mm. The integrating sphere uses both a photomultiplier and a PbS cell as detectors. Angle of incident light: 7°; acquisition parameters allowed to minimize both grating and detector changes during the scans. Measured spectral range : 240nm-2400nm , 990nm-2010nm. Diffuse Reflectance has been evaluated using Barium Sulphate ($BaSO_4$, WAKO™ Pure Chemical Industries Ltd.) compressed powder as a reference standard material for baseline correction. Data in Figure 3 and 4 show that compositions according to the invention comprising fluoropolymer a) and acrylate-based polymer b) in the weight ratio a) to b) from about 90:10 to about 30:70 exhibit higher reflectivity than a composition comprising 100% a) or b) alone and filler (Comparative Example 1). The maximum reflectivity value is observed for the composition comprising a) and b) in about 70:30 ratio.

Data in figure 5 show that comparative compositions comprising a filler having a D50 average particle size below 2 micrometers and a mixture of polymers a) and b) have a reflectivity lower than that of a composition comprising 100% of polymer a) and the same filler.

Figure 7 shows the results of stability tests conducted in a Damp Heat chamber (according to IEC EN 61215 - 10.13) on the compositions according to the invention and on the composition of Comparative Example 1, wherein data are normalized considering equal to 1 the initial reflectivity of the composition (T = 0). For the compositions according to the invention comprising a) and b) in 50:50 and 30:70 ratio, the reflectivity is stable and slightly increases over time. Notably, for the composition according to the invention comprising a) and b) in 70:30 ratio the reflectivity increases by up to 6% over time.

## Claims

1. A composition comprising:

   a) a fluoropolymer;
   b) an acrylate- or methacrylate-based co-polymer comprising 20-80% wt of recurring units derived from methyl methacrylate or methyl acrylate monomer and 20-80% wt of recurring units derived from a $C_2$-$C_8$ alkyl methacrylate or acrylate monomer, optionally with additional co-monomers;
   c) an inorganic filler, comprising a metal oxide, that reflects not less than 70% of at least an incident radiation having a wavelength comprised in the range from 0.78 micrometers to about 3 micrometers, wherein the filler c) is in the form of particles having an average size from 2 to 10 micrometers, the weight ratio of fluoropolymer a) to acrylate-based polymer b) is from 90:10 to 30:70 and the refractive index ($n_1$) of the mixture of a) and b) and the refractive index ($n_2$) of the filler c) are such that the ratio $n_1/n_2$ is not higher than 0.8.

2. The composition according to claim 1, wherein the fluoropolymer a) comprises recurring units deriving from the polymerization of vinylidene fluoride (VDF) monomer, optionally with monomers different from VDF.

3. The composition according to claim 2, wherein the fluoropolymer a) is vinylidene fluoride homopolymer (PVDF) or a co-polymer of VDF comprising:

(a') at least 60 % by weight, preferably at least 75 % by weight, more preferably at least 85 % by weight of vinylidene fluoride (VDF);
(b') optionally from 0.1 to 15 %, preferably from 0.1 to 12 %, more preferably from 0.1 to 10 % by weight of a fluorinated comonomer chosen among vinylfluoride (VF1), chlorotrifluoroethylene (CTFE), hexafluoropropene (HFP), tetrafluoroethylene (TFE), trifluoroethylene (TrFE), perfluoromethylvinylether (PMVE) and mixtures therefrom; and
(c) from 0.05 to 10 %, preferably from 0.1 to 7.5 %, more preferably from 0.2 to 3.0 % by weight of a monomer selected from the group consisting of: hydroxyethylacrylate (HEA), 2-hydroxypropyl acrylate (HPA), acrylic acid and mixtures thereof, wherein all the percentages are calculated as the ratio of the weight of a specific component of the copolymer divided by the total weight of the copolymer.

4. The composition according to any of the preceding claims, wherein the acrylate-based co-polymer b) is a co-polymer comprising 20-80% wt of recurring units derived from methyl methacrylate monomer and 20-80% wt of recurring units derived from a $C_2$-$C_8$ alkyl methacrylate or acrylate monomer.

5. The composition according to claim 4, wherein the acrylate-based polymer b) is a co-polymer comprising 50-80% wt, preferably 60-70% wt, of recurring units derived from methyl methacrylate monomer and 20-50% wt, preferably 30-40% wt, of recurring units derived from ethyl acrylate.

6. The composition according to any of the preceding claims, wherein the oxide in the inorganic filler c) is titanium dioxide incorporating metal atoms in the $TiO_2$ crystal lattice, preferably atoms of nickel, chromium, antimony, manganese and mixtures thereof.

7. The composition according to any of the preceding claims, wherein the sum of fluoropolymer a) and of acrylate-based polymer b) is from 50 to 95% wt, preferably 66 to 75%wt, and the amount of inorganic filler c) is from 5 to 50 %wt, preferably 25 to 33% wt, all amounts referred to the total weight of the composition.

8. The composition according to any of the preceding claims, wherein the weight ratio of fluoropolymer a) to acrylate-based polymer b) is from 85:15 to 40:60, preferably from 80:20 to 50:50, more preferably from 72:28 to 60:40, even more preferably from 70:30 to 65:35 .

9. The composition according to any of the preceding claims, wherein the average size of the particles of inorganic filler c) is from 3.5 to 8 micrometers, preferably 4 to 6 micrometers.

10. A sheet comprising the composition of any of the preceding claim.

11. A method for the formation of a sheet according to claim 10, wherein the method comprises:

i. preparing a solution or a suspension of fluoropolymer a) in a first liquid medium;
ii. mixing co-polymer b) with the solution or suspension of step i.;
iii. mixing to the composition obtained in step iii. the inorganic filler c) under stirring to obtain a homogeneous suspension;
iv. processing the suspension of step iii. into the form of a sheet.

12. An article comprising the composition of claim 1-9.

13. A photovoltaic module comprising a backsheet comprising at least a sheet according to claim 10, preferably as a backsheet.

14. A method of producing the sheet according to claim 10, comprising coating a layer of non-plastic material or non-fluoropolymeric plastic material with the composition of any of claims 1-9.

15. A method of producing the sheet according to claim 10, comprising laminating a layer of non-plastic material or non-fluoropolymeric plastic material with a layer comprising the composition of any of claims 1-9.

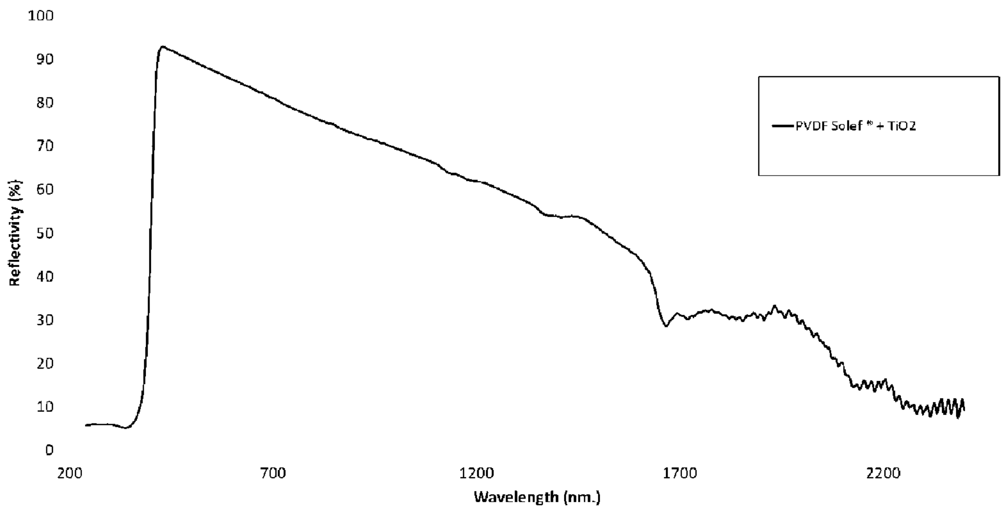
100
90
80
70
60
50
40
30
20
10
0
Reflectivity (%)
200
700
1200
1700
2200
Wavelength (nm.)
PVDF Solef ® + TiO2

**Fig. 1**

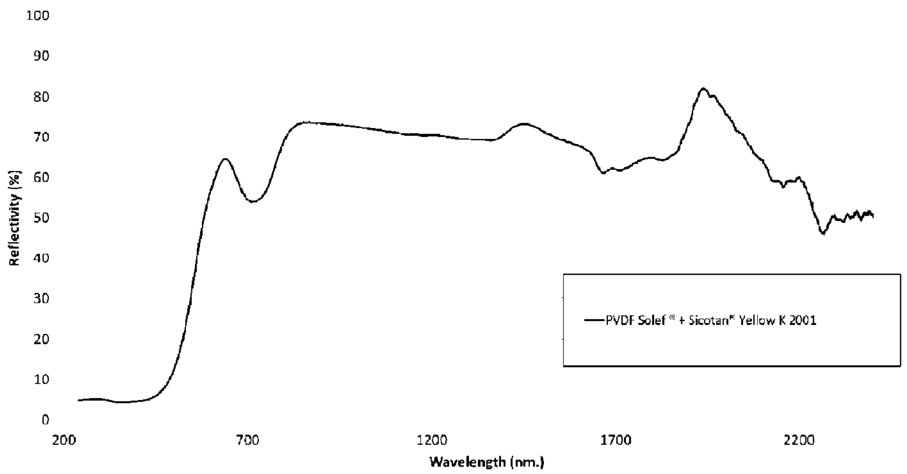
100
90
80
70
60
50
40
30
20
10
0
Reflectivity (%)
200
700
1200
1700
2200
Wavelength (nm.)
PVDF Solef ® + Sicotan® Yellow K 2001

**Fig. 2**

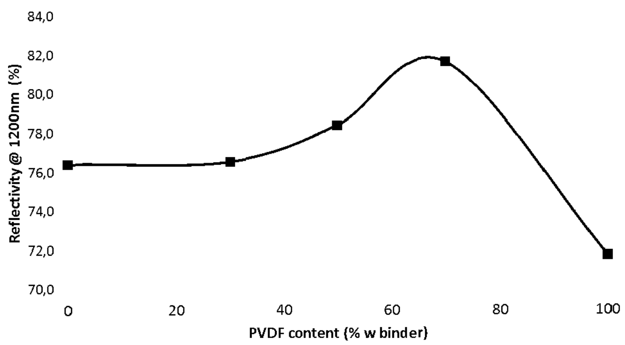
84,0
82,0
80,0
78,0
76,0
74,0
72,0
70,0
Reflectivity @ 1200nm (%)
0
20
40
60
80
100
PVDF content (% w binder)

Fig. 3

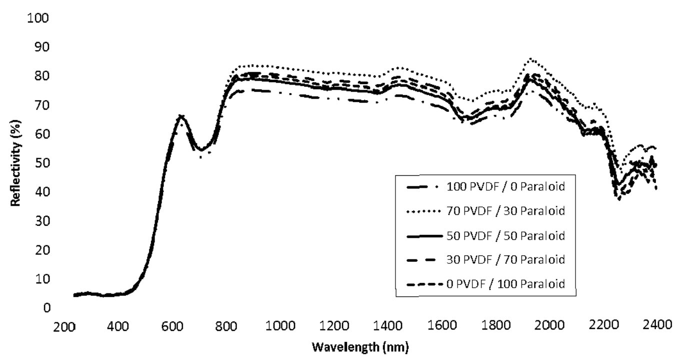
100
90
80
70
60
50
40
30
20
10
0
Reflectivity (%)
200
400
600
800
1000
1200
1400
1600
1800
2000
2200
2400
Wavelength (nm)
100 PVDF / 0 Paraloid
70 PVDF / 30 Paraloid
50 PVDF / 50 Paraloid
30 PVDF / 70 Paraloid
0 PVDF / 100 Paraloid

Fig. 4

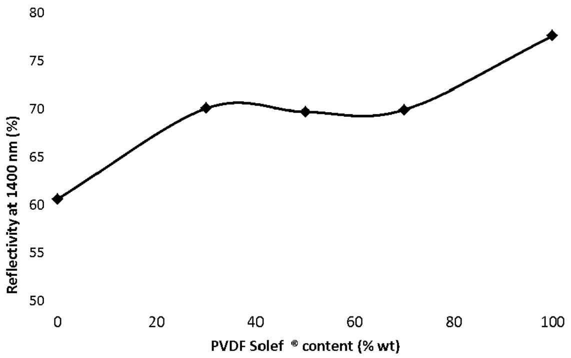
80
75
70
65
60
55
50
Reflectivity at 1400 nm (%)
0
20
40
60
80
100
PVDF Solef ® content (% wt)

Fig. 5

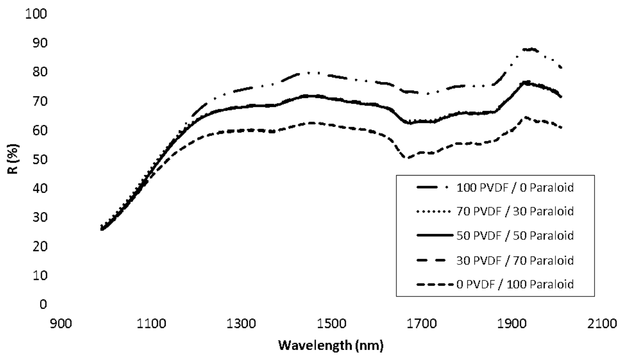
100
90
80
70
60
50
40
30
20
10
0
R (%)
900
1100
1300
1500
1700
1900
2100
Wavelength (nm)
100 PVDF / 0 Paraloid
70 PVDF / 30 Paraloid
50 PVDF / 50 Paraloid
30 PVDF / 70 Paraloid
0 PVDF / 100 Paraloid

Fig.6

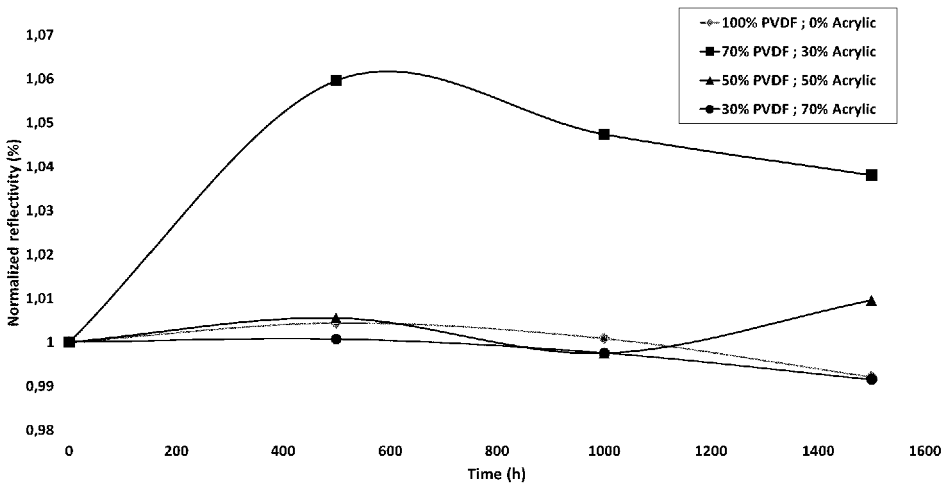
100% PVDF ; 0% Acrylic
70% PVDF ; 30% Acrylic
50% PVDF ; 50% Acrylic
30% PVDF ; 70% Acrylic
1,07
1,06
1,05
1,04
1,03
1,02
1,01
1
0,99
0,98
Normalized reflectivity (%)
0
200
400
600
800
1000
1200
1400
1600
Time (h)

Fig. 7

Europäisches Patentamt
European Patent Office
Office européen des brevets

# EUROPEAN SEARCH REPORT

Application Number
EP 15 16 2472

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 2 722 362 A1 (KUREHA CORP [JP]) 23 April 2014 (2014-04-23)<br>* claims 2,8 *<br>* example 1 *<br>----- | 1-15 | INV.<br>C09D127/16<br>C08L27/16<br>H01L31/049 |
| A | WO 2014/057933 A1 (DENKI KAGAKU KOGYO KK [JP]) 17 April 2014 (2014-04-17)<br>* claims 4,5 *<br>* paragraph [0050] *<br>----- | 1-15 | ADD.<br>C08K3/22 |
| A | US 2013/276876 A1 (KERKAR AWDHOOT V [US] ET AL) 24 October 2013 (2013-10-24)<br>* claims 1,2,3,5 *<br>* example 1 *<br>----- | 1-15 | |
| | | | TECHNICAL FIELDS SEARCHED (IPC) |
| | | | C09D<br>C08L<br>C08K<br>H01L |

1

The present search report has been drawn up for all claims

| Place of search | Date of completion of the search | Examiner |
|---|---|---|
| The Hague | 29 September 2015 | Rodríguez, Luis |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 15 16 2472

This annex lists the patent family members relating to the patent documents cited in the above-mentioned European search report.
The members are as contained in the European Patent Office EDP file on
The European Patent Office is in no way liable for these particulars which are merely given for the purpose of information.

29-09-2015

| Patent document cited in search report | Publication date | Patent family member(s) | Publication date |
|---|---|---|---|
| EP 2722362 A1 | 23-04-2014 | CN 103582671 A | 12-02-2014 |
| | | EP 2722362 A1 | 23-04-2014 |
| | | JP WO2012172876 A1 | 23-02-2015 |
| | | KR 20140026604 A | 05-03-2014 |
| | | US 2014102533 A1 | 17-04-2014 |
| | | WO 2012172876 A1 | 20-12-2012 |
| WO 2014057933 A1 | 17-04-2014 | NONE | |
| US 2013276876 A1 | 24-10-2013 | CN 104508836 A | 08-04-2015 |
| | | EP 2839512 A1 | 25-02-2015 |
| | | JP 2015519735 A | 09-07-2015 |
| | | KR 20150003741 A | 09-01-2015 |
| | | US 2013276876 A1 | 24-10-2013 |
| | | WO 2013158351 A1 | 24-10-2013 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7985919 B
- US 20130276876 A
- WO CN20140604 A

### Non-patent literature cited in the description

- Design, Fabrication and Testing, Sources and Detectors, Radiometry and Photometry. **BASS, M. et al.** Handbook of Optics. 13 October 2009, vol. II